# EUROPEAN PATENT APPLICATION

(11) **EP 3 029 836 A1**
(43) Date of publication of application: **08.06.2016**
(21) Application number: 15197734.5
(22) Date of filing: 03.12.2015
(51) Int. Cl.: H03K 17/785, H03K 17/74, H02M 1/092

(54) **FAIL-SAFE INTERFACE**

(30) Priority: 03.12.2014 GB 201421503
(71) Applicant: Control Techniques Ltd, Newtown, Powys SY16 3BE (GB)
(72) Inventor: HARGIS, Colin, Newtown, Powys SY16 3BE (GB)
(74) Representative: Morrall, Jonathan Ian McLachlan

(57) **Abstract**

A fail-safe interface circuit arranged to provide an inverter enable input to drive an inverter, the circuit being supplied by a first voltage and comprising: a charge pump comprising a charge pump input and a charge pump output, the charge pump output being coupled to a circuit output; and a pulsed input arranged to supply pulsed power to the charge pump input; wherein the charge pump output is arranged to produce a second voltage distinct from the first voltage only when the pulsed input is supplying pulsed power to the charge pump input, and wherein the circuit output is arranged to provide the inverter enable input when the second voltage is produced at the charge pump output.

## Description

This invention relates to a fail-safe interface. It is particularly suitable for an inverter enable input, and especially suited to an inverter enable input for a motor drive.

### Background

Machinery often comprises parts, which, during normal operation, would be hazardous to an operator should the operator come into contact with those parts when they are moving.

Such machinery is often driven by an electric motor. For safety reasons, it is often a requirement that a control system be employed for allowing and preventing operation of the electric motor (and hence machine operation) with a high level of integrity. For example, when a safety guard or gate is opened to allow access to a part of a machine that would be hazardous when moving, the motor must be prevented from driving the machine. A typical level of integrity for such a function would be a probability of dangerous failure of the order of 10⁻⁸ per hour. To achieve this, circuit design is employed that ensures that most component failures and combinations of failures result in the motor being prevented from driving the machine and, in turn, the machine not operating.

Traditionally, the ability to enable or disable the operation of the electric motor is achieved with electromechanical contactors, at least two of which would be arranged in series with the motor. The contactors are typically provided with auxiliary monitoring contacts so that an incorrect position of the main contacts of one contactor could be detected, and completion of the circuit prevented by disconnecting both coils of the electromagnets of the contactors.

Recently, solid-state controllers that drive an inverter to convert the d.c. supply into a phased set of a.c. supplies to produce a rotating magnetic field in the motor have been equipped with safety-related inputs. The inputs allow the operation of the motor to be prevented by electronic means.

In order to maintain torque in the motor, continual active and co-ordinated switching in the required sequence of the corresponding power semiconductors is needed. Should erroneous conduction of one or more of the power semiconductor devices of the inverter occur, this does not result in sustained torque in the motor. For a motor with a smooth (non salient) rotor, no torque is produced by any failure of a power semiconductor device of the inverter. For a motor with permanent magnets and/or saliency, a pair of short circuit power semiconductor devices in the inverter could cause a brief alignment torque whereby the motor partially rotates, however, the current would increase rapidly until interrupted by a protection device (for example a fuse) or destructive failure of at least one of the power semiconductor devices.

As a further example, in power grid-connected power generating inverter applications, the same principles apply when the inverter drives a transformer rather than a motor. Erroneous conduction of power semiconductor devices of the inverter cannot produce an alternating flux in the transformer, and therefore cannot produce a sustained output from the transformer secondary coil. In other words, a fault in the inverter power device results in direct current, which cannot be transferred through the transformer because the transformer relies upon alternating current for its operation.

In order for safe and reliable control of such an inverter, an interface is required between the inverter control input terminals which typically use logic signals such as 24V d.c. and the power semiconductors of the inverter that maintains the required low probability of dangerous failure of the inverter.

Electromechanical relays have been used to provide the necessary electrical isolation and electrical level conversion for such an interface. However, relays possess relatively high probabilities of failure in the dangerous direction and have a relatively short time before mechanical wearout. This results in pairs of relays being used accompanied by monitoring to detect fault conditions.

Recently, generation of the power semiconductor control signals for operating the inverter is typically carried out by complex digital electronic circuits and programmable digital processors. Such an arrangement does not provide the required low probability of dangerous failure as most digital circuits can fail with equal probability into either of the available logic states. Further, the complexity of the digital circuits and functions is such that it is difficult to reliably and confidently demonstrate a sufficiently low probability of dangerous failure under all combinations of conditions and sequences of conditions that the circuit may be subjected to during operation. For example, it may be difficult to predict how the circuit reacts under changeable temperature conditions together with each and every possible sequence of combinations of logic levels on each and every pin of the various devices of the circuit.

If complex digital electronic circuits and programmable circuits are to be employed in safety critical functions, typically, at least two independent channels together with diagnostic and cross-checking functions to detect faults or errors are used. These systems allow the disabling of an inverter by way of a channel that is not affected by a particular fault that has been detected. As can be seen, even in such systems, means for disabling the inverter which do not rely on the complex circuits needs to be provided in order to achieve the required low probability of dangerous failure.

It is therefore desirable to have a fail-safe interface, in particular, to an inverter, which employs simple electronic components with well-defined failure modes. In such an interface, it is desired that a very high fraction of component faults, and combinations of component faults, result in a safe failure. In other words, a failure where the inverter is not provided with the required waveform, and hence a motor connected to the inverter is not driven.

The same approach applies to power generators using inverters, in cases where under certain conditions, it is necessary to prevent the operation of the inverter with a high level of integrity. This could be, for example, when the part of a public power distribution network fed by an inverter has become separated from the main body of the power network and must be disabled.

### Summary of the Invention

According to a first aspect of the present invention there is provided a fail-safe interface circuit as defined in claim 1 of the appended claims. Thus there is provided a fail-safe interface circuit arranged to provide an inverter enable input to drive an inverter, the circuit being supplied by a first voltage and comprising: a charge pump comprising a charge pump input and a charge pump output, the charge pump output being coupled to a circuit output; and a pulsed input arranged to supply pulsed power to the charge pump input; wherein the charge pump output is arranged to produce a second voltage distinct from the first voltage only when the pulsed input is supplying pulsed power to the charge pump input, and wherein the circuit output is arranged to provide the inverter enable input when the second voltage is produced at the charge pump output.

Optionally, the pulsed input is supplied by the first voltage.

Optionally, the polarity of the second voltage is opposite to the polarity of the pulsed input.

Optionally, the magnitude of the second voltage is greater than a peak magnitude of the pulsed input.

Optionally, the circuit is further arranged to provide a second inverter enable input to drive the inverter, the circuit being further supplied by a third voltage, the circuit further comprising: a second charge pump comprising a second charge pump input and a second charge pump output, the second charge pump output being coupled to a second circuit output; and a second pulsed input arranged to supply pulsed power to the second charge pump input; wherein the second charge pump output is arranged to produce a fourth voltage distinct from the third voltage only when the second pulsed input is supplying pulsed power to the second charge pump input, and wherein the circuit output and the second circuit output are arranged to provide the first and second inverter enable inputs respectively when the second and fourth voltages are produced at the respective first and second charge pump outputs.

Optionally, the second pulsed input is supplied by the third voltage.

Optionally, the polarity of the third voltage is opposite to the polarity of the second pulsed input.

Optionally, the magnitude of the third voltage is greater than a peak magnitude of the second pulsed input.

Optionally, at least one isolator device is arranged to produce the inverter enable input when coupled between the circuit output and the inverter input.

Optionally, at least one isolator device is arranged to produce the second inverter enable input when coupled between the second circuit output and the second inverter enable input.

Optionally, the isolator devices comprise electromagnetic devices, for example opto-isolators.

Optionally, the inverter comprises a polyphase inverter.

Optionally, the inverter is arranged to drive a motor.

Optionally, the first and second voltages are of opposite polarity and/or of different magnitude.

Optionally, the third and fourth voltages are of opposite polarity and/or of different magnitude.

Optionally, the second and fourth voltages are of different magnitude and/or of different polarity.

Optionally, the first, second, third and fourth voltages are each of different magnitude.

Optionally, the fail-safe interface is a fail-safe interface of the inverter.

According to a second aspect of the present invention there is provided a method of providing a fail-safe interface as defined in claim 12 of the appended claims. Thus there is provided a method of providing a fail-safe interface, the method providing an inverter input to drive an inverter, the method comprising: providing a first voltage to a charge pump, the charge pump comprising a charge pump input and a charge pump output; coupling the charge pump output to a circuit output; supplying the charge pump input with pulsed power from a pulsed input and thereby producing a second voltage at the charge pump output, the second voltage being distinct from the first voltage; and providing the inverter input via the circuit output when the second voltage is produced at the charge pump output.

Optionally, the second pulsed input is supplied by the third voltage.

Optionally, the polarity of the third voltage is opposite to the polarity of the second pulsed input.

Optionally, the magnitude of the third voltage is greater than a peak magnitude of the second pulsed input.

Optionally, at least one isolator device is arranged to produce the inverter enable input when coupled between the circuit output and the inverter input.

Optionally, at least one isolator device is arranged to produce the second inverter enable input when coupled between the second circuit output and the second inverter enable input.

Optionally, the isolator devices comprise electromagnetic devices, for example opto-isolators.

Optionally, the inverter comprises a polyphase inverter.

Optionally, the inverter is arranged to drive a motor.

Optionally, the first and second voltages are of opposite polarity and/or of different magnitude.

Optionally, the third and fourth voltages are of opposite polarity and/or of different magnitude.

Optionally, the second and fourth voltages are of different magnitude and/or of different polarity.

Optionally, the first, second, third and fourth voltages are each of different magnitude.

Optionally, the fail-safe interface is a fail-safe interface of the inverter.

Further optional features are defined in the dependent claims.

### Brief Description of the Drawings

Embodiments will now be described, by way of example only, and with reference to the drawings in which:
Figure 1 illustrates a system overview diagram of a single channel fail-safe interface in accordance with embodiments described herein;
Figure 2 illustrates a system overview diagram of a two channel fail-safe interface in accordance with embodiments described herein;
Figure 3 illustrates a channel of the fail-safe interface providing a positive output according to embodiments described herein;
Figure 4 illustrates a channel of the fail-safe interface providing a negative output according to embodiments described herein;
Figure 5 illustrates a channel of the fail-safe interface providing a positive boost output according to embodiments described herein;
Figure 6 illustrates a channel of the fail-safe interface providing a negative boost output according to embodiments described herein;
Figure 7 illustrates a system diagram of a channel of the fail-safe interface providing a disable input of a portion of an inverter according to an embodiment;
Figure 8 illustrates a system diagram of a channel of the fail-safe interface providing a disable input of another portion of an inverter according to an embodiment;
Figure 9 illustrates a system diagram of a two channel fail-safe interface according to an embodiment.

In the figures, like elements are indicated by like reference numerals throughout.

### Overview

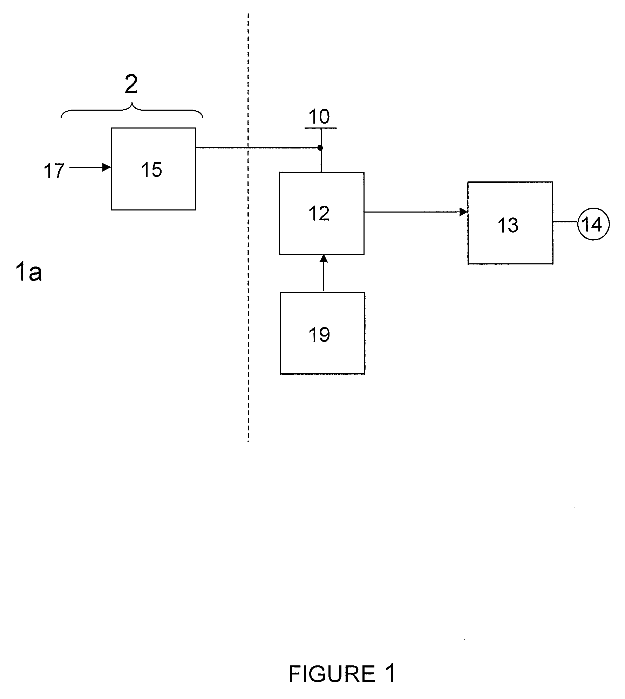

In overview, a fail-safe interface 1a, denoted by the left hand side of the dotted line of Figure 1, provides a reliable enable/disable function of an output 10. The output 10 is a power rail of the circuit to the right hand side of the dotted line. The output may power an isolator 12 that, in turn, may drive an electric motor 14 by way of an inverter 13. The reliable enable/disable function is provided by a charge pump 15 that produces the output 10. The output 10 is referred to herein as a terminal output. The terminal output 10 is either of opposite polarity to an enable input 17 of the charge pump 15, or the terminal output 10 is a boost output that is higher in magnitude than any other power rail or input in the fail-safe interface. An isolator component 12 may be coupled to the terminal output 10 in a manner so that, without the presence of the terminal output 10, the isolator component 12 cannot operate. With no isolator output, the correct sequence of voltages and currents cannot be produced in the inverter 13 and hence, an electric motor 14 cannot be driven by the inverter 13.

The circuit is arranged so that when the enable input 17 is in the disable state, no failure can result in the charge pump 15 producing the terminal outputs 10. With no terminal output, even if an attempt is made to switch an isolator 12 in the required sequence for the inverter 13, for example by a PWM 19, the isolator cannot produce an output due to the arrangement of the isolator 12 and the terminal output 10.

Accordingly, a single channel fail-safe interface is provided where the channel 2 can be enabled and disabled. The channel 2 comprises the safety-related parts for the fail-safe interface as will be discussed further herein.

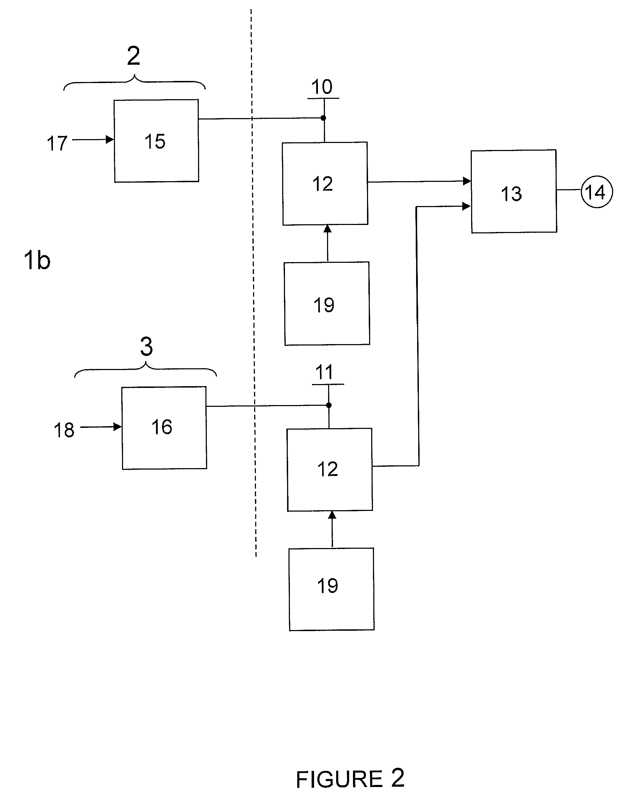

Figure 2 shows a two channel fail-safe interface 1 b comprising the channel 2 and another channel 3. The channel 3 provides a reliable enable/disable function of a terminal output 11. The terminal output 11 is a different power rail than terminal output 10, and is also a power rail of the circuit to the right hand side of the dotted line. The reliable enable/disable function of channel 3 is provided by a charge pump 16 that produces the output 11. The terminal output 11 is either of opposite polarity to an enable input 18 of the charge pump 16, or the terminal output 11 is a boost output that is higher in magnitude than any other power rail or input in the fail-safe interface. The operation of the channel 3 is substantially identical to the operation of channel 2, except that the terminal output 11 may be a different polarity and/or magnitude than the terminal output 10.

In figure 2, a reliable enable/disable function is provided by one or both of the outputs 10, 11. Accordingly, a two channel fail-safe interface is provided where each channel 2, 3 can be independently enabled and disabled.

It is clear therefore that either one channel (figure 1) or two channels (figure 2) can provide a fail-safe interface for an electric motor 14 by way of an inverter 13.

A solid-state drive which operates an AC motor or a brushless DC motor (a type of AC motor) is particularly suited to the fail-safe interface where the drive uses an inverter 13 to convert the DC supply into a phased set of AC supplies to produce a rotating magnetic field in the motor 14.

### Detailed Description

### Enable/Disable Function of Terminal Outputs 10, 11

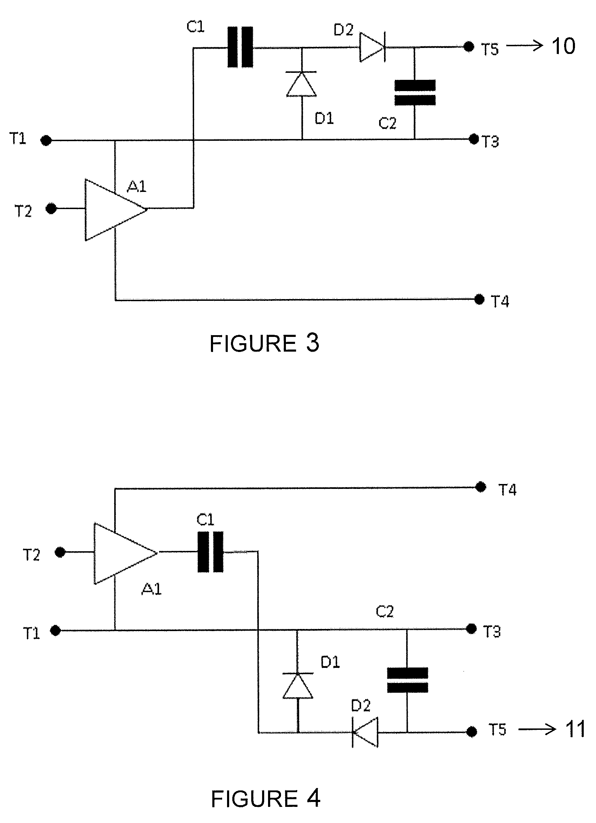

Figures 3 and 4 are arrangements in which the terminal outputs 10, 11 are of opposite polarity to the enable input 17, 18 of the respective charge pumps 15, 16.

Figure 3 shows an arrangement providing a positive terminal output 10. The enable input 17 to the arrangement of figure 3 is provided to terminals T1 and T2 due to the presence of a pulsed input known as a pulse wave or "pulse train". The pulse train may for example be a square wave and may be provided by an oscillator, for example a dedicated IC or other oscillator such as a 555 timer and associated support components. The oscillator may instead comprise discrete components including logic gates and/or transistors. T1 provides the reference line or "ground" line for the system, and is coupled to terminal T3. Since terminal T3 is an output terminal of the system, there is a common connection between the input (T1) and the output (T3). T2 provides the pulsed train referenced to T1. The pulse train provides alternating voltage outputs over time at T2: a peak voltage output, in which the voltage of the pulse train is at a maximum magnitude, or a zero voltage output. In the arrangement of figure 3, the pulse train is of negative pulses such that the peak output is a negative voltage with respect to T1.

The pulse train input provided at T2 is connected to an input of an amplifier A1. The amplifier A1 is such that it provides sufficient current to supply the output load, and may comprise an integrated amplifier, the output stage of an opto-coupler, or an amplifier comprised of discrete components of a conventional design. For example, the amplifier may be a push-pull complimentary emitter follower using bipolar transistors. In the present arrangement, the amplifier A1 is configured to be powered by a negative DC power supply voltage -V which is connected across terminals T3 (ground) and T4 of Figure 3. When the pulse train signal T2 is generating its peak output, i.e. a negative voltage with respect to the voltage at T1, the amplifier A1 also outputs a negative voltage which may be equal to the negative DC power supply across T3 and T4. When the pulse train signal T2 provides its zero output to the amplifier A1, A1 outputs at the same potential as the ground line T1/T3.

The output of amplifier A1 is connected to a charge pump comprising capacitors C1, C2 and diodes D1, D2. A first plate of the capacitor C1 is coupled to the output of the amplifier A1. A second plate of the capacitor C1 is coupled to both a cathode of diode D1 and an anode of diode D2. An anode of diode D1 is coupled to the ground line T1/T3, and a cathode of diode D2 is coupled to output terminal T5. The capacitor C2 is coupled between the terminal T5 and the ground line T1/T3. When the T2 pulse train is generating its peak output, i.e. a negative voltage, the amplifier A1 outputs a negative voltage -V to the first plate of the capacitor C1. As the diode D1 is coupled between the ground line T1/T3 and the second plate of the capacitor C1, the negative voltage -V provided by the amplifier A1 to the capacitor C1 therefore generates a potential V across the capacitor C1 due to the potential difference between the ground line T1/T3 and the output of the amplifier A1. The capacitor C1 is therefore charged as would be understood.

After the charging of C1, when the T2 pulse train is providing its zero output, the potential difference V across the capacitor C1 "pumps" a positive voltage output +V to a forward-biased diode D2 that connects to output terminal T5. The terminal T5 is the terminal output 10 of figures 1 or 2. Since the arrangement of figure 3 is supplied by a negative voltage -V at terminal T4, and outputs a positive voltage +V at terminal T5, the arrangement therefore provides an output voltage potential of 2*V (minus any inherent losses in the system), effectively doubling the voltage potential provided by the input power supply.

Figure 4 shows a further arrangement providing a negative terminal output 11. The enable input 18 to the arrangement of figure 4 is provided by terminals T1 and T2 due to the presence of a pulse train. T1 again provides a reference, or ground line for the system, and is connected to output terminal T3, and T2 provides the pulse train signal that generates peak voltage output and a zero voltage output. Unlike the arrangement of figure 3, in the arrangement of figure 4 the amplifier A1 is configured to be powered by a positive DC power supply +V which is connected at across terminals T3 (ground) and T4 of figure 4. Further, in the arrangement of figure 4, the pulse train is of positive pulses such that its peak output is a positive voltage with respect to the voltage at T1/T3. When the pulse train signal T2 is generating its peak output to the amplifier A1, the amplifier A1 outputs a positive voltage +V which may be equal to the positive DC power supply across T3 and T4.

In the arrangement of figure 4, the output of amplifier A1 is also connected to a charge pump comprising capacitors C1, C2 and diodes D1, D2 in a different configuration to that of figure 3. A first plate of the capacitor C1 is coupled to the output of the amplifier A1, as in figure 3. A second plate of the capacitor C1 is coupled to both an anode of diode D1 and a cathode of diode D2. A cathode of diode D1 is coupled to the ground line T1/T3, and an anode of diode D2 is coupled to the output terminal T5. The capacitor C2 is coupled between the terminal T5 and the ground line or reference T1/T3. When the T2 pulse train is generating its peak output, i.e. a positive voltage, the amplifier A1 also outputs a positive voltage +V, equal to the positive DC power supply across T3 and T4, to an input side of the capacitor C1. The diode D1 is connected between the ground line T1/T3 and an output side of capacitor C1. The positive voltage +V provided by the amplifier A1 to the capacitor C1 therefore generates a potential V across the capacitor C1. The capacitor C2 is therefore charged as would be understood.

After the charging of C1, when the T2 pulse train is providing its zero output, the potential difference V across C1 "pumps" a positive voltage output +V to the forward-biased diode D1 that connects to the ground line T1/T3. This results in a potential between output terminals T3 and T5 of V. However, since the ground line T1/T3 is held at ground level, T5 is therefore at a potential of -V relative to T3 in order to maintain the potential V across the terminals T3 and T5. In the arrangement of figure 4, the terminal T5 corresponds to terminal output 11 of figure 2. As the arrangement of figure 4 is supplied by a positive voltage +V at terminal T4, and outputs a negative voltage -V at terminal T5, the arrangement provides an output voltage of 2*V (minus any inherent losses in the system), effectively doubling the voltage potential provided by the input power supply.

In the arrangements of figures 3 and 4, the polarity of the terminal outputs 10, 11 (provided by the respective terminals T5) is reversed in relation to the polarity of the respective DC power supply inputs T4. This provides a fail-safe against many possible faults, including a combination of faults. One possible combination of faults is the input T2 becoming stuck high or low, or any other fault causing a stuck high or stuck low state, and a short circuit of the capacitor C1. In this case, any output at the terminal T5 will not be of the correct polarity for the driven circuit, since the polarity of the input T2 is not reversed by the charge pump. Therefore the output at terminal output 10, 11 (T5) will not cause the isolator(s) 12 to operate as the required voltage is not present at terminal outputs 10, 11.

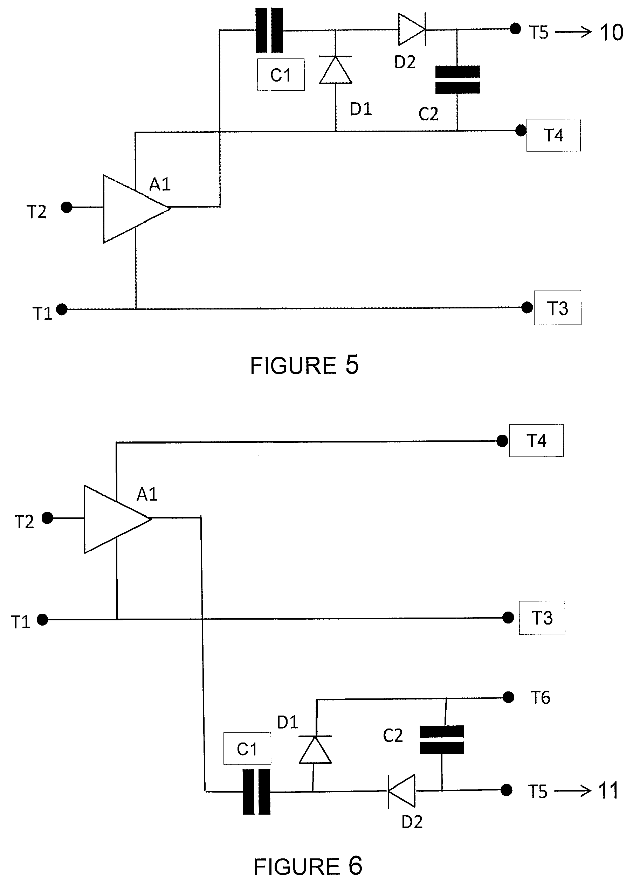

Figures 5 and 6 are alternative arrangements in which the terminal outputs 10, 11 are of a greater voltage magnitude than the enable input 17, 18 of the respective charge pump15, 16.

Figure 5 shows an arrangement providing a positive "boost" potential at output T5. The enable input 17 to the arrangement of figure 5 is provided by terminals T1 and T2 due to the present of a pulse train. T1/T3 again provides a ground line for the system. T2 provides the pulse train, positive in this case, to amplifier A1, as previously described in relation to figure 3. The power supply in this arrangement is a positive DC power supply voltage +V across terminals T4 and T3 (ground), and therefore the amplifier A1 is powered by the positive DC power supply.

In this arrangement, the pulse train provided by T2 is of positive pulses such that its peak voltage output is a positive voltage. Due to this, when the pulse train is generating its peak output, the amplifier A1 also outputs a positive voltage +V. The output of the amplifier A1 is connected to a charge pump of the same configuration as the charge pump of figure 3, except the anode of D1 is coupled to the highest positive DC power supply +V of the system T4 (as opposed to ground in figure 3).

In the arrangement of figure 5, terminals T4 and T5 are the output terminals. The circuit to be driven by the arrangement of figure 4, i.e. the one or more isolators 12 and subsequent circuitry (see figures 1 or 2), is such that the positive DC power supply voltage +V, provided at terminal T4, is insufficient to operate the driven circuit at terminal T5. A "boost" potential sufficient to operate the driven circuit is provided at T5 due to the charge pump, as will now be described.

When the T2 pulse train is providing its zero output, a potential V is generated across the capacitor C1 due to the potential difference between the T4 supply line (+V) and the output of the amplifier A1 (zero, or ground potential). The capacitor C1 is charged as would be understood. It is important to note that, even though the diodes D1 and D2 in the arrangement of figure 5 allow for current to flow from T4 to T5, as previously mentioned the DC power supply of T4 is insufficient to operate the driven circuit.

When the T2 pulse train is providing its positive peak output, the output of the amplifier A1 provides a voltage +V to the capacitor C1. The combination of the T4 supply line and the potential difference V across the capacitor C1 is such that a voltage of 2*V (minus any inherent losses in the system) is output at terminal T5, as would be understood. The arrangement of figure 5 also therefore effectively doubles the voltage potential of the input voltage supply across T3 and T4. As in the arrangement of figure 3, the terminal T5 is the terminal output 10 of figures 1 or 2.

Since the driven circuit requires a potential greater than that provided by the input power supply across the terminals T4 and T3, and since the power supplied by T3 is the highest power supply of the system, there are no failure modes that can occur in the event of a component fault. Any fault in the components would result in the charge pump failing, and therefore the boost potential required to operate the driven circuits would not be provided by T5.

Figure 6 shows an arrangement providing a negative "boost" potential at output T5. The enable input 18 to the arrangement of figure 6 is provided by terminals T1 and T2 due to the presence of a pulse train. T1/T3 again provides a ground line or reference for the system. T2 provides the pulse train, positive in this case, to amplifier A1, as previously described in relation to figure 3. One power supply in this arrangement is a positive DC power supply voltage +V across terminals T4 and T3 (ground), and therefore the amplifier A1 is powered by the positive DC power supply.

As for the arrangement of figure 5, the pulse train provided by T2 is of positive pulses such that its peak voltage output is a positive voltage. Due to this, when the pulse train is generating its peak output, the amplifier A1 also outputs a positive voltage +V. The output of the amplifier A1 is connected to a charge pump of the same configuration as the charge pump of figure 4, except that the cathode of diode D1 is coupled to a negative DC power supply, T6 (as opposed to ground in figure 4). T6 provides a negative potential -V with respect to T1/T3.

In the arrangement of figure 6, terminals T5 and T6 are the output terminals. The circuit to be driven by the arrangement of figure 5, i.e. the one or more isolators 12 and subsequent circuitry (see figures 1 or 2), is such that the positive DC power supply voltage +V, provided at terminal T4, is neither of the correct polarity nor sufficient in magnitude to operate the driven circuit at terminal T5. Additionally, the negative power supply provided at terminal T6 is not of sufficient magnitude to operate the driven circuit at terminal T5, in the case that a component failure allows such a coupling to T5. A negative "boost" potential sufficient to operate the driven circuit is provided at T5 due to the charge pump, as will now be described.

When the T2 pulse train is providing its positive peak output, the output of the amplifier A1 provides a voltage +V to the capacitor C1. Since the capacitor C1 is coupled to the negative supply rail T6, which provides a negative potential -V, the potential across the capacitor is -2*V. The capacitor C1 is charged as would be understood.

When the T2 pulse train is providing its zero output, the potential difference between the output of the amplifier A1 (0) and T5 is -2*V as this is the potential across the capacitor C1. Therefore, a voltage of -2*V (minus any inherent losses in the system) is output at terminal T5, as would be understood. The arrangement of figure 6 effectively doubles the magnitude, and reverses the polarity, of the voltage potential of the input voltage supply across T3 and T4. Said another way, the arrangement of figure 6 effectively doubles the voltage potential of the voltage supply across T3 and T6. As in the arrangement of figure 4, the terminal T5 is the terminal output 11 of figure 2.

As in figure 5, since the driven circuit requires a potential of greater magnitude and opposite polarity than that provided by the input power supply across the terminals T4 and T3, and since the power supplied by T6 is the highest negative power supply in the system, no failure modes can occur that allow the driven circuits to operate in the event of a component fault. Any fault in the components would result in the charge pump failing, and therefore the boost potential, of correct polarity and magnitude required to operate the driven circuits, would not be provided by T5. As such, there are no faults that can cause the potential at T5 to be more negative than the potential at T6.

Any of the individual arrangements of figures 3 to 6 can be used to provide the single channel fail-safe interface 1 a of figure 1. Additionally, any of the arrangements of figures 3 to 6 can be used together in order to provide the two channel fail-safe interface 1 b of figure 2. For example, the channel 2 could be provided by any of the arrangements of figures 3 to 6, and the channel 3 (if present) could also be provided by any of the arrangements of figures 3 to 6. Indeed, both channels 2 and 3 could each be provided by the same arrangement. For example, the channel 2 could be provided by the arrangement of figure 2, and the channel 3 could also be provided by the arrangement of figure 2,each channel controlled by a separate enable input. Accordingly, the terminal outputs 10, 11 provided by the charge pumps 15, 16 of each channel may comprise two positive outputs, two negative outputs, or an output of each polarity.

In all of the above arrangements, the frequency and duty cycle of the pulse train T2 can be adjusted such that the successive charging and discharging of the capacitor C1 produces a continuous positive (figures 3 and 5) or negative (figures 4 and 6) output at the terminal T5. Although the pulse train T2 is specified as being either positive pulses or negative pulses, it would be understood by the skilled person that the polarity of the pulses could be reversed by using AC coupling at the input to amplifier A1. For example, the arrangement of figure 3 could therefore operate using positive pulses.

In the above charge pumps, a resistor in series with C1 may be present, as would be understood, to limit the peak current flowing into the capacitor C1.

An optional capacitor C2 is provided across the terminals T3 and T5 (figures 3 and 4) or terminal T4 and T5 (figure 5) or terminals T5 and T6 (figure 6) in order to smooth the signal, as would be understood.

If the pulse train signal T2 fails in any of the above arrangements, then the input T2 is either in a stuck high state, a stuck low state or a tri-state and no terminal output 10, 11 can be produced by charging and discharging the capacitor C1. Further, in the event of any static fault in the amplifier A1 or any circuits driving it which also results in a stuck high or stuck low state, the terminal outputs 10, 11 also cannot be produced by charging and discharging the capacitor C1. In each failure mode, the required charge/discharge cycle is broken and hence the T5 supply would fail.

In can be seen that the above arrangements provide a safe (inhibited) condition of an inverter in the event of a large number of component faults, thereby eliminating all plausible unsafe failure modes. This is due to the charge pumps of figures 3-6 creating a power rail for the driven circuit by virtue of the terminal output 10, 11 (T5). The power rail of the driven circuit must be present, otherwise the driven circuit will not operate. The above arrangements are therefore intrinsically safe since the power rail of the driven circuit is not provided unless the charge pump(s) is operating as intended. No failures in the circuitry of figures 3-6 can result in the appropriate power rail for the driven circuit being provided.

### Fail-safe Inverter Disable Input

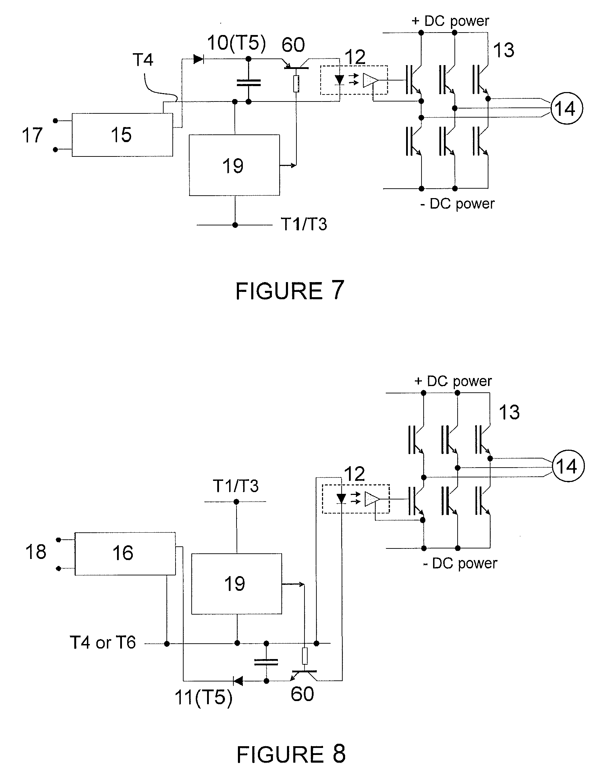

Figure 7 shows a system diagram of an example of a single channel fail-safe interface providing an inverter disable input where the terminal output 10 (T5) is of a positive polarity. The channel of figure 7 is therefore provided by the arrangement of figure 3 or figure 5. An isolator 12 may be coupled between the terminal output 10 and the power supply across T3 and T4. Isolator 12 may comprise an opto-isolator with an LED as shown in figure 7, or may be any similar device capable of producing light or other electromagnetic energy, or any other device capable of providing electrical isolation whose design is such that it intrinsically cannot produce an output if its input is of the wrong polarity. The LED may have its anode coupled to the terminal output 10 by a discrete switching device 60. Switching device 60 may be a bipolar transistor, a MOSFET or any other suitable device. PWM 19 provides coupling of the LED anode to terminal output 10 via switching device 60 and is operable to modulate the isolator 12 output. Any suitable means of modulation may be used in place of PWM 19 such as voltage vector control or flux vector control where the pulse widths are adjusted using a variety of techniques to optimise an aspect of the behaviour of the motor or the load. These alternatives provide pulses with modulated width. Another suitable modulation technique is quasi-square operation, i.e. without width modulation.

As can be seen, the LED of the opto-isolator can be illuminated only when the terminal output 10 is appropriately enabled by the corresponding enable input 17. Even if the PWM 19 attempts to couple the LED to terminal output 10, the isolator 12 cannot provide an output without terminal output 10 providing the appropriate output.

Should the isolator 12 be coupled to a power semiconductor of an inverter 13, then it is clear that, without the terminal output 10 of appropriate polarity and/or magnitude, the power semiconductor cannot be driven, and hence the inverter cannot provide the required waveform to a connected motor 14. In Figures 7 and 8, only one isolator is shown for clarity however additional isolators can be coupled to the other power semiconductors of the inverter in a similar manner.

Any isolator 12 or other device connected in a manner corresponding to figure 6 is disabled when terminal output 10 is not of the necessary polarity and/or magnitude. The arrangement of figure 7 can be utilised with a three-phase inverter bridge 13 as shown, however, any polyphase inverter can be driven in this manner. Therefore, if motor torque is only produced when an approximation to the correct sequence of voltages and currents is generated, the reliable and fail-safe enable function of terminal output 10 provides reliable and fail-safe operation of motor 14 driven by inverter 13.

Figure 8 shows a system diagram of an example of a single channel fail-safe interface providing an inverter disable input where the terminal output 11 (T5) is of a negative polarity. The channel of figure 8 is therefore provided by the arrangement of figure 4 or figure 6. If the inverter control circuit has an internal negative supply rail then the arrangement of figure 6 is preferably used, with terminal T6 of figure 6 and the isolator LED 12 anode connected to this negative supply rail. Control of the inverter 13 by way of enable input 18 and isolator 12 is achieved in the same manner as that shown in figure 7.

With a three-phase inverter bridge 13, as shown in figures 7 and 8, the single channels of figures 7 and 8 may be combined to provide a two channel fail-safe control by coupling isolators 12 to either terminal output 10 or terminal output 11.

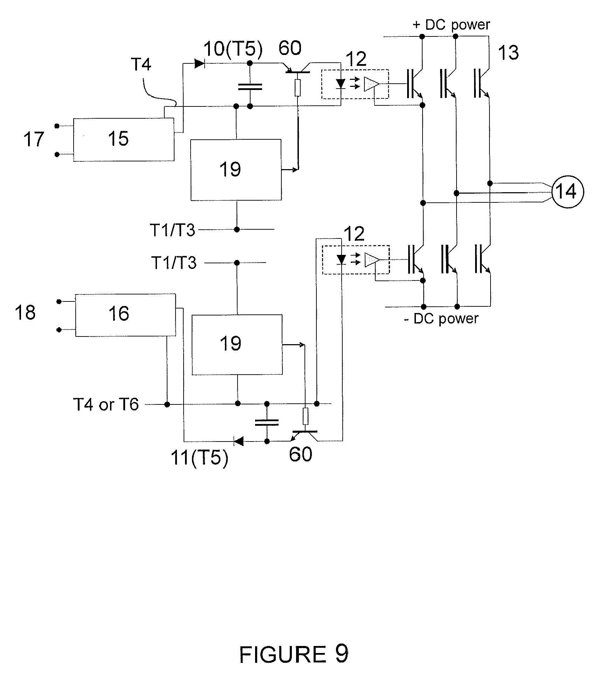

An example of such a two channel fail-safe control is shown in figure 9. The terminal outputs 10, 11 may comprise two positive outputs, two negative outputs, or an output of each polarity. Figure 9 illustrates the arrangement when terminal output 10 is positive and terminal output 11 is negative. However, the polarities of the terminal outputs 10 and 11 could be reversed, 10 being negative and 11 being positive, or the terminal outputs 10 and 11 could have the same polarity. Accordingly, one or more of the arrangements of figures 3 to 6 could be used to provide the two channel fail-safe control shown in figure 9.

As shown, the two independent channels 2, 3 each control the terminal output for three of the six power semiconductor devices of inverter 13. Independence of the two channels is obtained by segregating the components of figures 3 to 6 as described in the failure mode section below.

The top three power semiconductors of the inverter may be controlled by three isolators 12 coupled to terminal output 10 by three corresponding switching devices 60 (only one such isolator is shown for clarity), and the bottom three power semiconductors of the inverter may be controlled by three isolators 12 coupled to terminal output 11 by three corresponding switching devices (only one such isolator is shown for clarity).

With such a two-channel arrangement, both enable inputs 17, 18 must be in the enabled state for the appropriate corresponding terminal output 10, 11 to be produced which, in turn, allows the isolator to produce an output to drive the corresponding power semiconductor of the inverter. A cross-check can be performed between the separate enable outputs 17, 18 for indication of a malfunction. Any mismatch between the two channels and the fail-safe interface could be shutdown.

The isolators 12 are illustrated as opto-isolators. However, alternative isolators comprising transformers or capacitance coupling arrangements could also be employed in the fail-safe interface.

### Failure Modes

Various potential failure modes will now be described where a dangerous fault could affect the integrity of the fail-safe interface. It will be shown that no fault can reduce the integrity of the enable/disable function, thereby providing the ability to disable an inverter drive with high integrity.

All components in the charge pumps 15, 16 shown in figures 3 to 6 may be discrete parts that possess well-defined failure modes (for example short circuit, open circuit, leakage, value change with time and temperature etc). Depending on the application, the use of a discrete component amplifier A1 may be beneficial by removing the possibility of a failure mode which results in spurious oscillation of the amplifier, which could cause a dangerous failure.

The charge pumps are arranged so that there are no component faults within the charge pumps or amplifier A1 that could cause inadvertent output to the terminal output 10, 11 (T5) which is sufficient to operate the driven circuit. Transfer of power to each terminal output 10, 11 relies upon the operation of the charge pump, since either the terminal outputs 10, 11 require a voltage of an opposite polarity to the input power supply (figures 3 and 4) or the terminal outputs 10, 11 require a voltage of greater magnitude than that provided by the input power supply (figures 5 and 6). Failure of any component prevents the reversal of polarity or the increase in voltage magnitude, and therefore the inverter cannot operate.

As has been disclosed herein, there is provided a fail-safe interface which allows low-level control signals 17 and/or 18 to reliably enable and disable the power semiconductor devices 13 of an inverter drive. The following advantages are realised:
1. In the single channel embodiment of figure 1, all of the safety-related components are contained in a single circuit. No faults or combinations of faults in the circuit that is used with the fail-safe interface can result in unintended production of the terminal output 10 and hence unintended torque in the motor 14.
2. In the two channel embodiment of figure 2, all of the safety-related components are contained in a single circuit comprising two independent channels 2, 3. These channels may be positioned on a discrete circuit board together (with PCB layout discipline to avoid one terminal output 10, 11 being able to leak onto another), or for added resilience to failure, on one discrete circuit board per channel. As has been shown, no faults or combinations of faults in any other circuit that is used with the fail-safe interface can result in unintended production of terminal outputs 10, 11 and hence unintended torque in motor 14.
3. In the embodiment where the two channels produce terminal outputs of opposite polarity, no other circuit can exhibit a fault that is able to cause one terminal output to be energised because the other is energised. In this embodiment, if an energised terminal output were to leak onto an unenergised terminal output, the isolators 12 on the unenergised terminal output would require a terminal output of opposing polarity to that provided by the leaking terminal output in order to be biased correctly for operation. When opposing terminal output polarities are used, the PCB layout discipline when both channels are positioned on the same circuit board may therefore be relaxed as even if one terminal output leaks onto the other, erroneous isolator 12 output cannot occur.
4. The single or two channel fail-safe interface can be used with many inverter designs, and further, the portions of the overall circuit arranged to control the inverter drive need not be assessed in detail for their failure effects as they will have no effect on the integrity of the fail-safe function of the channels 2 and/or the channel 3.
5. All of the safety-related parts of the channels 2 and/or the channel 3 may be common electronic components for which mature failure rate data exists, and for which the failure modes are well-defined.
6. When coupled to an inverter bridge 13 via an isolator 12, no single component failure and no combination of two independent component failures can result in unintended production of appropriate polarity voltage at the terminal output 10 and/or the terminal output 11, or in unintended production of voltage of sufficient magnitude at these terminal outputs, and hence unintended production of torque in the motor 14.

Described herein is a fail-safe interface comprising a safe and reliable enable function provided by way of discrete components with well-defined failure modes. The interface does not require complex circuits or architecture, nor electro-mechanical devices that are inherently unreliable, have a short life expectancy, and are expensive.

Whilst particular embodiments and arrangements have been illustrated and described herein, other arrangements are possible without departing from the scope of the invention as set out in the claims. For example, more than two channels could be combined to provide a higher degree of cross-checking.

## Claims

1. A fail-safe interface circuit arranged to provide an inverter enable input to drive an inverter, the circuit being supplied by a first voltage and comprising:
a charge pump comprising a charge pump input and a charge pump output, the charge pump output being coupled to a circuit output; and
a pulsed input arranged to supply pulsed power to the charge pump input;
wherein the charge pump output is arranged to produce a second voltage distinct from the first voltage only when the pulsed input is supplying pulsed power to the charge pump input, and wherein the circuit output is arranged to provide the inverter enable input when the second voltage is produced at the charge pump output.

2. The circuit of claim 1 wherein the pulsed input is supplied by the first voltage.

3. The circuit of claim 1 or claim 2 wherein the polarity of the second voltage is opposite to the polarity of the pulsed input and/or optionally wherein the magnitude of the second voltage is greater than a peak magnitude of the pulsed input.

4. The circuit of any preceding claim wherein the circuit is further arranged to provide a second inverter enable input to drive the inverter, the circuit being further supplied by a third voltage, the circuit further comprising:
a second charge pump comprising a second charge pump input and a second charge pump output, the second charge pump output being coupled to a second circuit output; and
a second pulsed input arranged to supply pulsed power to the second charge pump input;
wherein the second charge pump output is arranged to produce a fourth voltage distinct from the third voltage only when the second pulsed input is supplying pulsed power to the second charge pump input, and wherein the circuit output and the second circuit output are arranged to provide the first and second inverter enable inputs respectively when the second and fourth voltages are produced at the respective first and second charge pump outputs.

5. The circuit of claim 4 wherein the second pulsed input is supplied by the third voltage.

6. The circuit of claim 4 wherein the polarity of the third voltage is opposite to the polarity of the second pulsed input, and/or the magnitude of the third voltage is greater than a peak magnitude of the second pulsed input.

7. The circuit of any preceding claim wherein at least one isolator device is arranged to produce the inverter enable input when coupled between the circuit output and the inverter enable input.

8. The circuit of any of claims 4 to 7 wherein at least one isolator device is arranged to produce the second inverter enable input when coupled between the second circuit output and the second inverter enable input.

9. The circuit of any preceding claim wherein the first and second voltages are of opposite polarity and/or optionally different magnitude.

10. The circuit of any of claims 4 to 9 wherein the third and fourth voltages are of opposite polarity and/or optionally different magnitude, and/or further optionally wherein the second and fourth voltages are of different magnitude and/or of different polarity.

11. The circuit of any of claims 4 to 10 wherein the first, second, third and fourth voltages are each of different magnitude.

12. A method of providing a fail-safe interface, the method providing an inverter enable input to drive an inverter, the method comprising:
providing a first voltage to a charge pump, the charge pump comprising a charge pump input and a charge pump output;
coupling the charge pump output to a circuit output;
supplying the charge pump input with pulsed power from a pulsed input and thereby producing a second voltage at the charge pump output, the second voltage being distinct from the first voltage; and
providing the inverter enable input via the circuit output when the second voltage is produced at the charge pump output.

13. The method of claim 12 wherein the pulsed input is supplied by the first voltage.

14. The method of claim 12 or claim 13 wherein the polarity of the second voltage is opposite to the polarity of the pulsed input and/or optionally wherein the magnitude of the second voltage is greater than a peak magnitude of the pulsed input.

15. The method of any of claims 12 to 14 further comprising providing a second inverter enable input to drive the inverter, and further comprising:
providing a third voltage to a second charge pump, the second charge pump comprising a second charge pump input and a second charge pump output;
coupling the second charge pump output to a second circuit output;
supplying the second charge pump input with pulsed power from a second pulsed input thereby producing a fourth voltage at the second charge pump output, the fourth voltage being distinct from the third voltage; and
providing the first and second inverter enable inputs via the circuit output and the second circuit output respectively.
